(19) Europäisches Patentamt
European Patent Office
Office européen des brevets

(11) Veröffentlichungsnummer: **0 243 784 B1**

(12) **EUROPÄISCHE PATENTSCHRIFT**

(45) Veröffentlichungstag der Patentschrift: **29.07.92**

(51) Int. Cl.$^5$: **G03F 7/031**

(21) Anmeldenummer: **87105501.8**

(22) Anmeldetag: **14.04.87**

# (54) Photopolymerisierbares Gemisch und dieses enthaltendes photopolymerisierbares Aufzeichnungsmaterial.

(30) Priorität: **23.04.86 DE 3613632**

(43) Veröffentlichungstag der Anmeldung:
**04.11.87 Patentblatt 87/45**

(45) Bekanntmachung des Hinweises auf die Patenterteilung:
**29.07.92 Patentblatt 92/31**

(84) Benannte Vertragsstaaten:
**DE FR GB IT**

(56) Entgegenhaltungen:
**EP-A- 0 220 589**
**BE-A- 723 475**
**DE-A- 1 522 499**
**DE-A- 1 817 540**
**US-A- 3 751 259**
**US-A- 3 870 524**
**US-A- 3 959 100**
**US-A- 4 258 123**
**US-A- 4 548 892**
**US-A- 4 555 474**

(73) Patentinhaber: **HOECHST AKTIENGESELLSCHAFT**
**Postfach 80 03 20**
**W-6230 Frankfurt am Main 80(DE)**

(72) Erfinder: **Frommeld, Hans-Dieter, Dr.**
**Simrockstrasse 7A**
**W-6200 Wiesbaden(DE)**
Erfinder: **Vollmann, Hansjörg, Dr.**
**Am Dachsbau 11**
**W-6232 Bad Soden-Neuenhain(DE)**

EP 0 243 784 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein photopolymerisierbares Gemisch, das als wesentliche Bestandteile ein polymeres Bindemittel, eine ethylenisch ungesättigte polymerisierbare Verbindung, einen Farbstoff und einen Photoinitiator enthält.

Gemische dieser Art dienen zur Herstellung von Druckplatten, Reliefbildern und Photoresists und sind z. B. aus den DE-C 1 171 267, 2 027 467 und 2 039 861 sowie den DE-A 15 22 575, 20 64 079 und 20 64 080 (= US-A 3 804 631) bekannt. Besondere Bedeutung haben sie als Aufzeichnungsmaterialien für die photomechanische Herstellung von Flachdruckformen und für die Photoresisttechnik.

Derartige Gemische oder Materialien enthalten in der photopolymerisierbaren Schicht normalerweise Farbstoffe oder Pigmente, um das Reliefbild nach dem Entwickeln besser sichtbar zu machen. Die farbigen Zusätze sollen naturgemäß lichtecht sein, da die nach dem Entwickeln verbleibende Bildschablone, die aus den lichtgehärteten Schichtteilen besteht, möglichst kontrastreich bleiben soll.

Als eine weitere Komponente enthalten diese Gemische Photoinitiatoren, die das Licht der in handelsüblichen Kopiergeräten verwendeten Metallhalogenidlampen ($\lambda > 350$ nm) absorbieren.

Es ist bekannt, daß organische Halogenverbindungen Licht absorbieren und Radikale abspalten, die eine Photopolymerisationsreaktion einleiten können. Die Mehrzahl dieser organischen Halogenverbindungen absorbieren aber nur im kurzwelligen UV-Bereich ($\lambda < 350$ nm).

Durch Einbau chromophorer Reste in trichlormethylgruppenhaltige Heterocyclen wurde der Versuch unternommen, eine Absorption solcher Verbindungen in den längerwelligen Bereich zu verschieben. Absorptionsbanden zwischen 350 und 450 nm werden für Triazinderivate in den DE-A 22 43 621 und 27 18 259, Oxadiazolderivate in den DE-A 28 51 472 und 29 49 396, Oxazole in den DE-A 30 21 590 und 30 21 599 oder auch Thiazole in den EP-A 0 135 348 und 0 135 863 beschrieben.

Daneben sind Arbeiten bekannt, in denen Halogenverbindungen durch Zusatz von Sensibilisatoren, die teilweise mäßig wirksam sind, für die Photoreaktion sensibilisiert werden:

In den DE-A 28 51 641 und 29 34 758 wird die Kombination von Trihalogenmethyltriazinen mit 2-Benzoylmethylen-naphtho[1,2-d]thiazol und in der DE-A 26 10 842 ein Gemisch aus N-Phenylacridon und Trihalogenmethylverbindungen beschrieben.

Ferner können auch $\alpha$-Halogencarbonsäureamide (DE-A 27 18 200) oder Tribrommethyl-phenylsulfone (DE-A 35 03 113) durch Photoinitiatoren wie z.B. Benzophenon, Benzil oder Michlers Keton sensibilisiert werden.

In der US-A 4 258 123 wird ein photopolymerisierbares Material beschrieben, das als Photoinitiator eine Kombination aus einer Trihalogenmethyl-s-triazinverbindung und bestimmten fünfgliedrigen, mit einem Benzol- oder Naphthalinring kondensierten Heterocyclen enthält.

In der US-A 4 555 474 wird ein ähnliches Gemisch beschrieben, das als Heterocyclen neben anderen auch Chinolinderivate enthalten kann.

Diese Bestrebungen hatten zum Ziel, die Lichtempfindlichkeit der photopolymerisierbaren Gemische durch eine verbesserte Lichtabsorption des Photoinitiatorsystems zu erhöhen. Diese Zielsetzung ist heute immer noch aktuell.

Aufgabe der Erfindung war es, photopolymerisierbare Gemische mit höherer Lichtempfindlichkeit als bekannte Gemische vorzuschlagen, die zugleich lagerstabil sind.

Erfindungsgemäß wird ein photopolymerisierbares Gemisch vorgeschlagen, das als wesentliche Bestandteile

a) ein polymeres Bindemittel,
b) eine Verbindung mit mindestens einer endständigen ethylenischen Doppelbindung und
c) eine Acridin-, Phenazin- oder 2,3-Dihydro-1H-cyclopenta[b]chinolinverbindung als Photoinitiator

enthält.

Das erfindungsgemäße Gemisch ist dadurch gekennzeichnet, daß es zusätzlich eine Halogenverbindung einer der allgemeinen Formeln I und II

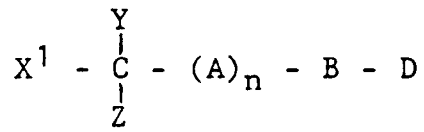 (I)

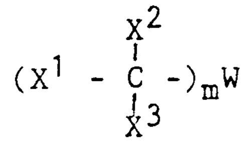 (II)

enthält, worin

| | |
|---|---|
| $X^1$ | Chlor oder Brom bedeutet, |
| $X^2$ und $X^3$ | gleich oder verschieden sind und $X^1$, Wasserstoff oder Alkylgruppen bedeuten, |
| Y und Z | gleich oder verschieden sind und $X^1$, Wasserstoff, CN oder $(A)_n$-$(B)_n$-Dbedeuten, |
| A | eine Phenylengruppe, |
| n | 0 oder 1, |
| B | CO oder $SO_2$, |
| D | R, OR, NHR, $NH_2$, $NR_2$ oder $CX^1X^2X^3$, |
| R | ein Alkyl-, Cycloalkyl-, Aryl- oder Heteroylrest, |
| W | ein 5- oder 6-gliedriger heterocyclischer Ring mit 1 bis 3 Heteroatomen, der ggf. Substituenten und ggf. einen anellierten aromatischen Ring trägt, und |
| m | 1 oder 2 ist. |

In den allgemeinen Formeln I und II haben die Symbole insbesondere die folgende Bedeutung:
$X^1$, $X^2$ und $X^3$ sind vorzugsweise Cl. In den Verbindungen der Formel II sind $X^1$, $X^2$ und $X^3$ vorzugsweise Chloratome. In den Verbindungen der Formel I ist mindestens einer, vorzugsweise sind mindestens zwei der Reste $X^1$, Y und Z jeweils ein Halogenatom. Von den Resten Y und Z ist im allgemeinen nicht mehr als einer, vorzugsweise ist keiner von ihnen ein Wasserstoffatom. Bevorzugt ist nicht mehr als einer dieser Reste eine CN-Gruppe oder eine Gruppe $(A)_n$-$(B)_n$-D. Wenn B eine $SO_2$-Gruppe ist, ist bevorzugt keine weitere $SO_2$-Gruppe im Molekül enthalten.

Wenn A eine Phenylengruppe ist, kann diese unsubstituiert oder durch Halogenatome, Alkyl- oder Alkoxygruppen mit 1 - 2 Kohlenstoffatomen substituiert sein.

D ist vorzugsweise R, NHR, $NH_2$ oder, wenn zwei Reste D im Molekül sind, $CX^1X^2X^3$.

R kann ein Alkylrest mit 1 - 6, vorzugsweise 1 - 3 Kohlenstoffatomen sein. Wenn R eine Cycloalkylgruppe ist, hat diese bevorzugt 5 bis 6 Ringglieder. Sie kann durch Alkyl- oder Alkoxygruppen mit 1 oder 2 Kohlenstoffatomen substituiert sein. Wenn R ein Arylrest ist, ist dieser bevorzugt ein Phenylrest, der ggf. durch Halogenatome, Nitrogruppen, Alkyl- oder Alkoxygruppen mit 1 - 4, vorzugsweise 1 oder 2 Kohlenstoffatomen, substituiert sein kann.

Wenn R ein Heteroylrest ist, kann dieser im allgemeinen von einem 5- oder 6-gliedrigen Heterocyclus abgeleitet sein, der vorzugsweise N, O und bzw. oder S als Heteroatome enthalt. Der Ring kann gesättigt oder ungesättigt und gegebenenfalls durch Alkyl- oder Alkoxygruppen mit 1 oder 2 Kohlenstoffatomen substituiert sein.

Der heterocyclische Ring W in der Formel II kann als Heteroatome N, O oder S enthalten und ist vorzugsweise aromatisch. Der anellierte aromatische Ring ist vorzugsweise ein Benzolring.

Als Substituenten im heterocyclischen Ring kommen u. a. Halogenatome, Alkylgruppen mit 1 bis 5 Kohlenstoffatomen, Alkoxygruppen mit 1 bis 3 Kohlenstoffatomen und ein- oder zweikernige Arylgruppen in Betracht, die wiederum durch Halogenatome, Alkyl- oder Alkoxygruppen mit 1 bis 3 Kohlenstoffatomen, Aralkylgruppen mit 7 bis 10 Kohlenstoffatomen oder Aralkenylgruppen mit 8 bis 10 Kohlenstoffatomen substituiert sein können. Der Ring kann auch Carbonylgruppen als Ringglieder enthalten, wie im 2-Pyronring.

Verbindungen mit Halogenatomen, die durch -CO-, $-SO_2-$ oder durch einen heterocyclischen Rest aktiviert werden, sind in den bereits als Stand der Technik zitierten Schriften erwähnt.

Von besonderer Bedeutung sind z. B. folgende Substanzen:

$C_6H_5 - SO_2 - CBr_3$

$C_6H_5 - SO_2 - CBr_2 - C_6H_5$

$C_6H_5 - SO_2 - CBr_2 - CN$

$C_6H_5 - SO_2 - CCl_2 - CN$

$C_6H_5 - SO_2 - CBr_2 - CO - NH_2$
$C_6H_5 - SO_2 - CCl_2 - CO - N(C_2H_5)_2$
$CBr_3 - SO_2 - CBr_2 - CO - C_6H_5$
$C_6H_5 - SO_2 - CBr_2 - CO - C_6H_5$
$C_6H_5 - SO_2 - CBr_2 - CO - OCH_3$
$NH_2 - CO - CBr_2 - CO - NH_2$
$CH_3 - NH - CO - CBr_2 - CO - NH - CH_3$

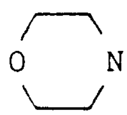

$- CO - CBr_2 - CN$ $NO_2 - C_6H_4 - CO - CBr_3$
$C_6H_5 - CO - CBr_2 - CO - CBr_3$
$CCl_3 - C_6H_5 - CO - NH - C_6H_4Cl$
$CCl_3 - C_6H_5 - CO - NH - C_6H_4 - O - C_2H_5$

2-Alkyl- oder 2-Aryl-4,6-bis(trihalogenmethyl)-s-triazine, Trihalogenmethylchinoline, z. B. 4- und 2-Tribrommethylchinolin; Trichlormethyl- oder Tribrommethylgruppen enthaltende Oxazole, Oxadiazole oder 2-Pyrone.

Von diesen Verbindungen sind insbesondere Tribrommethylphenylsulfon, 2,2-Dibrommalonsäurebisamid, $\alpha,\alpha$-Dibrom$\alpha$-cyanomethyl-phenylsulfon, $\alpha,\alpha$-Dibrom-$\alpha$-benzoylmethylphenylsulfon, $\alpha,\alpha$-Dibrommalonsäure-bis-N-methylamid, 4,6-Bis(trichlormethyl)-s-triazine oder 2-Tribrommethylchinolin anzuwenden, wobei von den 4,6-Bis(trichlormethyl)-s-triazinen vorzugsweise die in 2-Stellung substituierten Derivate in Frage kommen. Als Substituenten werden insbesondere Methyl-, Ethyl-, Phenyl-, 4-Methoxyphenyl- oder 4'-Styrylphenyl- eingesetzt.

Geeignete N-heterocyclische Verbindungen werden in der DE-A 20 27 467 genannt. Es handelt sich vorzugsweise um Acridinderivate. Weiterhin kommen Phenazine in Frage, bei denen an den äußeren Ringen A und C insgesamt 1 oder 2 Benzolringe anelliert sind und die an einem der Ringe A und C bis zu zwei Alkylgruppen mit 1 bis 5 C-Atomen oder Alkoxygruppen mit 1 bis 5 C-Atomen tragen. Auch die in der EP-A 220 589 beschriebenen 2,3-Dihydro-1H-cyclopenta[b]chinolinderivate sind geeignet. Bevorzugt werden Acridine, die in der 9-Stellung substituiert sind, vorzugsweise 9-Arylacridine, insbesondere 9-Phenylacridine.

Zu nennen sind: 9-Phenylacridine, 9-(4'-Tolyl)-acridine, 9-(4'-Methoxyphenyl)-acridine, 9-(4'-Hydroxyphenyl)-acridine, 9-Acetylamino-acridine, Benz[a]phenazine, 8-Methyl-benz[a]phenazine, 9,10-Dimethylbenz[a]phenazine, 9-Methyl-benz[a]phenazine, 10-Methyl-benz[a]phenazine, 9-Methoxy-benz[a]phenazine, 10-Methoxy-benz[a]phenazine, Dibenz[a,c]phenazine, 11-Methoxy-dibenz[a,c]phenazine, Dibenz[a,j]-phenazine, davon insbesondere 9-Phenylacridin, 9-(4'-Tolyl)-acridin, Benz[a]phenazin, 9-Methyl-benz[a]-phenazin und 3-(o-Chlor-benzyliden)-9-phenyl-2,3-dihydro-1H-cyclopenta[b]chinolin.

Sowohl die N-heterocyclische Verbindung als auch die Halogenverbindung nach Formel I oder II werden im allgemeinen jeweils in einer Menge von 0,01 bis 3,0, vorzugsweise von 0,05 bis 2,0 Gew.-%, bezogen auf die nichtflüchtigen Bestandteile des Gemisches, eingesetzt. Das Mengenverhältnis kann 0,01 bis 10, bevorzugt 0,05 bis 3 Gewichtsteile Halogenverbindung I oder II zu 1 Gewichtsteil N-heterocyclischer Verbindung betragen.

Für die Zwecke der Erfindung geeignete polymerisierbare Verbindungen sind bekannt und z. B. in den US-A 2 760 863 und 3 060 023 beschrieben.

Bevorzugte Beispiele sind Acryl- und Methacrylsäureester von zwei- oder mehrwertigen Alkoholen, wie Ethylenglykoldiacrylat, Polyethylenglykoldimethacrylat, Acrylate und Methacrylate von Trimethylolethan, Trimethylolpropan, Pentaerythrit und Dipentaerythrit und von mehrwertigen alicyclischen Alkoholen. Mit Vorteil werden auch Umsetzungsprodukte von Diisocyanaten mit Partialestern mehrwertiger Alkohole eingesetzt. Derartige Monomere sind in den DE-A 20 64 079, 23 61 041 und 28 22 190 beschrieben.

Der Mengenanteil der Schicht an Monomeren beträgt im allgemeinen etwa 10 bis 80, vorzugsweise 20 bis 60 Gew.-%.

Als Bindemittel kann eine Vielzahl löslicher organischer Polymerisate Einsatz finden. Als Beispiele seien genannt: Polyamide, Polyvinylester, Polyvinylacetale, Polyvinylether, Epoxidharze, Polyacrylsäureester, Polymethacrylsäureester, Polyester, Alkydharze, Polyacrylamid, Polyvinylalkohol, Polyethylenoxid, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Ferner kommen als Bindemittel Naturstoffe oder umgewandelte Naturstoffe in Betracht, z. B. Gelatine

und Celluloseether.

Mit besonderem Vorteil werden Bindemittel verwendet, die wasserunlöslich, aber in wäßrig-alkalischen Lösungen löslich oder mindestens quellbar sind, da sich Schichten mit solchen Bindemitteln mit den bevorzugten wäßrigalkalischen Entwicklern entwickeln lassen. Derartige Bindemittel können z. B. die folgenden Gruppen enthalten: -COOH, -$PO_3H_2$, -$SO_3H$; -$SO_2NH$-, -$SO_2$-NH-$SO_2$- und -$SO_2$-NH-CO-.

Als Beispiele hierfür seien genannt: Maleinatharze, Polymerisate aus N-(p-Tolyl-sulfonyl)-carbaminsäure-ß-(methacryloyloxy)-ethylester und Mischpolymerisate dieser und ähnlicher Monomerer mit anderen Monomeren sowie Vinylacetat/Crotonsäure- und Styrol/Maleinsäureanhydrid-Mischpolymerisate. Alkylmethacrylat/Methacrylsäure-Mischpolymerisate und Mischpolymerisate aus Methacrylsäure, höheren Alkylmethacrylaten und Methylmethacrylat und/oder Styrol, Acrylnitril u. a., wie sie in den DE-A 20 64 080 und 23 63 806 beschrieben sind, werden bevorzugt.

Die Menge des Bindemittels beträgt im allgemeinen 20 bis 90, vorzugsweise 40 bis 80 Gew.-% der Bestandteile der Schicht.

Die photopolymerisierbaren Gemische können je nach geplanter Anwendung und je nach den gewünschten Eigenschaften verschiedenartige Stoffe als Zusätze enthalten. Beispiele sind:

Haftvermittler, Inhibitoren zur Verhinderung der thermischen Polymerisation der Monomeren, Wasserstoffdonatoren, die sensitometrischen Eigenschaften derartiger Schichten modifizierende Stoffe, Farbstoffe, Farbstoffvorstufen, z. B. Leukobasen; gefärbte und ungefärbte Pigmente, Weichmacher, z.B. Polyglykole oder Ester der p-Hydroxybenzoesäure.

Beispiele für geeignete Zusätze sind Schwefelverbindungen, wie Mercaptobenzimidazol, Mercaptobenzthiazol, Thioharnstoff oder Thioharnstoffderivate, Tetraalkylthiuramsulfid, -disulfid oder -polysulfide; Verbindungen mit dreiwertigem Phosphor wie Triphenylphosphin oder Triphenylphosphit; ferner Ascorbinsäure, Imidazol oder Imidazolderivate.

Diese Bestandteile sind zweckmäßig so auszuwählen, daß sie in dem für den Initiierungsvorgang wichtigen aktinischen Strahlungsbereich möglichst wenig absorbieren.

Als Farbstoffe können Triarylmethanfarbstoffe, Azofarbstoffe oder auch Anthrachinonfarbstoffe in Frage kommen, die auch in Kombination mit Leukobasen von Triarlmethanfarbstoffen Anwendung finden.

Geeignete Triarylmethanfarbstoffe sind u.a.: Kristallviolett, Victoriablau BH, Victoriareinblau BOH, Methylviolett, Fuchsin, Malachitgrün, Acid Violet 5B, Solar Cyanine 6 B, Brillantgrün und Acilanviolett S, gegebenenfalls ihre Leukoderivate.

Von den Anthrachinonfarbstoffen können Beizenfarbstoffe, saure Farbstoffe, Dispersionsfarbstoffe und Küpenfarbstoffe verwendet werden; besonders hervorzuheben ist das Disperse Blue 134 (CI 61 551).

Als Vertreter eines Azofarbstoffs sei das Produkt aus der Umsetzung von 2,4-Dinitro-6-chlorbenzoldiazoniumsalz und 2-Methoxy-5-acetylamino-N-cyanoethyl-N-hydroxyethylanilin genannt.

Der Gehalt des photopolymerisierbaren Gemisches an Leukobasen, bezogen auf seine nichtflüchtigen Bestandteile, beträgt 0 bis 2,5 %, vorzugsweise 0,8 bis 2,0 %. Der entsprechende Inhalt an Farbstoffen liegt im allgemeinen bei 0,02 bis 1,5 , vorzugsweise bei 0,04 bis 1,0 %. Das Mengenverhältnis zwischen Farbstoff und Leukobase liegt vorzugsweise zwischen 1,5:0 und 1:1,25.

Als aktinische Strahlung soll im Rahmen dieser Beschreibung jede Strahlung verstanden werden, deren Energie mindestens der des kurzwelligen sichtbaren Lichts entspricht. Geeignet ist langwellige UV-Strahlung, aber auch Laserstrahlung.

Das photopolymerisierbare Gemisch kann für die verschiedensten Anwendungen Einsatz finden, beispielsweise zur Herstellung von Lacken, die durch Licht gehärtet werden, und insbesondere als lichtempfindliches Aufzeichnungsmaterial auf dem Reproduktionsgebiet.

Die detaillierte Beschreibung der Erfindung beschränkt sich auf dieses Anwendungsgebiet, jedoch ist die Erfindung nicht hierauf beschränkt. Als Anwendungsmöglichkeiten auf diesem Gebiet seien genannt: Aufzeichnungsschichten für die photomechanische Herstellung von Druckformen für den Hochdruck, den Flachdruck, den Tiefdruck, den Siebdruck, von Reliefkopien, z. B. Herstellung von Texten in Blindenschrift, von Einzelkopien, Gerbbildern, Pigmentbildern usw.. Weiter sind die Gemische zur photomechanischen Herstellung von Ätzreservagen, z. B. für die Fertigung von Namensschildern, von kopierten Schaltungen und für das Formteilätzen, verwendbar. Besondere Bedeutung haben die erfindungsgemäßen Gemische als Kopierschichten für die photomechanische Herstellung von Flachdruckformen und für die Photoresisttechnik.

Die gewerbliche Verwertung des Gemischs für die genannten Anwendungszwecke kann in der Form einer flüssigen Lösung oder Dispersion, z. B. als Photoresistlösung, erfolgen, die vom Verbraucher selbst auf einen individuellen Träger, z. B. zum Formteilätzen, für die Herstellung kopierter Schaltungen, von Siebdruckschablonen und dgl., aufgebracht wird. Das Gemisch kann auch als feste lichtempfindliche Schicht auf einem geeigneten Träger in Form eines lagerfähig vorbeschichteten lichtempfindlichen Kopiermaterials, z. B. für die Herstellung von Druckformen, vorliegen. Ebenso ist es für die Herstellung von Trockenresist geeignet.

Es ist im allgemeinen günstig, die Gemische während der Lichtpolymerisation dem Einfluß des Luftsauerstoffes weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z. B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt. Hierfür geeignete Materialien sind z. B. Wachse, Polyvinylalkohol, Polyphosphate, Zucker usw..

Als Schichtträger für mit dem erfindungsgemäßen Gemisch hergestellte Kopiermaterialien sind beispielsweise Aluminium, Stahl, Zink, Kupfer und Kunststoff-Folien, z. B. aus Polyethylenterephthalat oder Cellulosacetat, sowie Siebdruckträger, wie Perlongaze, geeignet.

Die Herstellung der lichtempfindlichen Materialien unter Verwendung des erfindungsgemäßen Gemischs erfolgt in bekannter Weise.

So kann man dieses in einem Lösungsmittel aufnehmen und die Lösung bzw. Dispersion durch Gießen, Sprühen, Tauchen, Antrag mit Walzen usw. auf den vorgesehenen Träger als Film antragen und anschließend antrocknen. Dicke Schichten (z. B. von 250 µm und darüber) werden vorteilhaft durch Extrudieren oder Verpressen als selbsttragende Folie hergestellt, welche dann ggf. auf den Träger laminiert wird. Im Falle von Trockenresist werden Lösungen des Gemischs auf transparente Träger aufgebracht und angetrocknet. Die lichtempfindlichen Schichten - Dicke etwa zwischen 10 und 100 µm - werden dann gleichfalls zunächst zusammen mit dem temporären Träger auf das gewünschte Substrat auflaminiert.

Die Verarbeitung der Materialien wird in bekannter Weise vorgenommen. Zur Entwicklung werden sie mit einer geeigneten Entwicklerlösung, z. B. mit organischen Lösemitteln, aber bevorzugt mit einer schwach alkalischen wäßrigen Lösung, behandelt, wobei die unbelichteten Anteile der Schicht entfernt werden und die belichteten Bereiche der Kopierschicht auf dem Träger zurückbleiben.

Überraschenderweise ergibt sich eine besondere Steigerung der Lichtempfindlichkeit, wenn basische, N-heterocyclische Photoinitiatoren, insbesondere des Acridin-und Phenazintyps mit bekannten Halogenverbindungen, die eingangs als Stand der Technik gewürdigt wurden, kombiniert werden.

Eine derartig hohe Lichtempfindlichkeit wird weder durch die Einzelkomponenten des Photoinitiatorsystems noch durch Kombinationen der an sich bekannten Halogenverbindungen mit anderen als den erfindungsgemäß eingesetzten N-heterocyclischen Verbindungen erreicht.

Die folgenden Beispiele erläutern bevorzugte Ausführungsformen der Erfindung. Mengenverhältnisse und Prozentzahlen sind in Gewichtseinheiten zu verstehen, wenn nichts anderes angegeben ist. Die Mengen an Bestandteilen sind in der Regel in Gewichtsteilen (Gt) angegeben. Das Zeichen (V) hinter einer Beispielsvariante gibt an, daß es sich um ein Vergleichsbeispiel handelt.

Die Beispiele 1, 3, 4, 5 (C) und 7 zeigen in vergleichender Weise die Zusammenwirkung von 9-Phenylacridin, das Beispiel 2 diejenige von 9-(4'Tolyl)-acridin und Beispiel 5 (D,E) diejenige von Benz[a]-phenazin mit unterschiedlichen Halogenverbindungen auf.

Beispiel 1

In Beschichtungslösungen aus

| | |
|---|---|
| 40 Gt | eines Copolymerisats aus Methylmethacrylat und Methacrylsäure (Säurezahl 115), |
| 40 Gt | Trimethylolpropantriacrylat und |
| 0,5 Gt | Disperse Blue 134 (CI 61551) in |
| 520 Gt | 2-Methoxyethanol |

wurden als Photoinitiatoren

| | | |
|---|---|---|
| A(V) | 0,7 Gt | 2-(4'-Methoxynaphth-1-yl)-4,6-bis-(trichlormethyl)-s-triazin, |
| B(V) | 0,7 Gt | 2-(p-Trichlormethyl-benzoylmethylen)-3-ethylbenzthiazolin, |
| C(V) | 0,7 Gt | 2-Phenyl-4,6-bis(trichlormethyl)-s-triazin, |
| D(V) | 0,7 Gt | 9-Phenylacridin, |
| E(V) | 0,2 Gt | 2-Phenyl-4,6-bis(trichlormethyl)-s-triazin und |
| | 0,5 Gt | 2-Benzoylmethylen-3-methyl-naphtho-[1,2-d]thiazolin, |
| F(V) | 0,2 Gt | 2-Phenyl-4,6-bis(trichlormethyl)-s-triazin und |
| | 0,5 Gt | N-Phenylacridon, |
| G | 0,2 Gt | 2-Phenyl-4,6-bis(trichlormethyl)-s-triazin und |
| | 0,5 Gt | 9-Phenylacridin, |
| H | 0,2 Gt | Tribrommethyl-phenylsulfon und |
| | 0,5 Gt | 9-Phenylacridin oder |
| I | 0,2 Gt | 2,2-Dibrommalonsäurebisamid und |
| | 0,5 Gt | 9-Phenylacridin |

gelöst. Die Lösungen wurden auf elektrolytisch aufgerauhtes und durch Anodisierung gehärtetes 0,3 mm starkes Aluminium durch Aufschleudern aufgetragen. Die Schicht wurde 2 Minuten bei 100 °C getrocknet, wobei man ein Schichtgewicht von 3,0 g/$m^2$ erhielt.

Die lichtempfindlich beschichteten Platten wurden mit einer 15%igen wäßrigen Lösung von Polyvinylalkohol (12 % Restacetylgruppen, K-Wert 4) überzogen und erneut getrocknet, wobei man ein Schichtgewicht von 4 bis 5 g/$m^2$ erhielt.

Die so erhaltenen Druckplatten wurden mit einer 5-kW-Metallhalogenidlampe 15 Sekunden in einem Abstand von 110 cm unter einer Negativvorlage zusammen mit einem 13-stufigen Belichtungskeil, der Dichteinkremente von 0,15 enthält, belichtet.

Die durch Licht nicht gehärteten Teile wurden durch Überwischen mit einer Entwicklerlösung folgender Zusammensetzung entfernt:

| | |
|---|---|
| 3 Gt | Natriummetasilikat x 9 $H_2O$, |
| 0,05 Gt | Strontiumchlorid, |
| 0,03 Gt | nichtionogenes Netzmittel (Kokosfettalkohol-Polyoxyethylenether mit ca. 8 Oxyethyleneinheiten), |
| 0,003 Gt | Antischaummittel, |
| 100 Gt | vollentsalztes Wasser. |

Die Zahl der voll durchgehärteten Stufen des Belichtungskeils gibt eine Maßzahl für die Lichtempfindlichkeit an. Die Werte sind in der folgenden Tabelle für die Muster A bis I zusammengestellt.

| Versuch | Zahl der Stufen |
|---|---|
| A (V) | 4 |
| B (V) | 5 |
| C (V) | 0 |
| D (V) | 4 |
| E (V) | 3 |
| F (V) | 0 |
| G | 7 |
| H | 7 |
| I | 7 |

Wurde im Versuch F 2-Phenyl-4,6-bis(trichlormethyl)-s-triazin durch gleiche Gewichtsmengen 2,4,6-Tris-α,α-dichlorethyl-s-triazin oder 4,6-Trichlormethyl-s-triazin-2-carbonsäureethylester ersetzt, so wurden vergleichbare Ergebnisse erhalten.

Beispiel 2

In Beschichtungslösungen aus

| | |
|---|---|
| 39 Gt | eines Copolymerisats aus Methylmethacrylat und Methacrylsäure (Säurezahl 115), |
| 39 Gt | Trimethylolethantriacrylat, |
| 0,1 Gt | Kristallviolett und |
| 1,5 Gt | Leukokristallviolett in |
| 450 Gt | 1-Methoxypropan-2-ol und |
| 75 Gt | Butanon |

wurden als Photoinitiatoren

| | | |
|---|---|---|
| A(V) | 0,7 Gt | 2-(4'-Methoxystyryl)-4,6-bis-(trichlormethyl)s-triazin, |
| B(V) | 0,7 Gt | 2-(4'-Ethoxynaphth-1-yl)4,6-bis-(trichlormethyl)-s-triazin, |
| C(V) | 0,5 Gt<br>0,2 Gt | 2-Benzoylmethylen-3-methyl-naphtho-[1,2-d]thiazolin und<br>2-Methyl-4,6-bis(trichlormethyl)-s-triazin, |
| D(V) | 0,7 Gt | 9-p-Tolylacridin, |
| E | 0,5 Gt<br>0,2 Gt | 9-p-Tolylacridin und<br>2-(4'-Methoxystyryl)-4,6-bis(trichlormethyl)-s-triazin, |
| F | 0,5 Gt<br>0,2 Gt | 9-p-Tolylacridin und<br>Tribrommethyl-phenylsulfon, |
| G | 0,5 Gt<br>0,2 Gt | 9-p-Tolylacridin und<br>2-Methyl-4,6-bis(trichlormethyl)-s-triazin, |
| H | 0,5 Gt<br>0,2 Gt | 9-p-Tolylacridin und<br>2-Tribrommethylchinolin, |
| I | 0,5 Gt<br>0,2 Gt | 9-p-Tolylacridin und<br>Dibrom-cyanomethyl-phenylsulfon, |
| K | 0,5 Gt<br>0,2 Gt | 9-p-Tolylacridin und<br>$\alpha,\alpha$-Dibrom-$\alpha$-benzoylmethyl-phenylsulfon, |
| L(V) | 0,7 Gt | Tribromethyl-phenylsulfon, |
| M(V) | 0,7 Gt | 2-Methyl-4,6-bis(trichlormethyl)-s-triazin oder |
| N(V) | 0,7 Gt | 2-Tribrommethylchinolin |

gelöst. Die Lösungen wurden wie im Beispiel 1 auf vorbehandeltes Aluminium aufgebracht und nach dem Trocknen (Schichtgewicht 2,8 $g/m^2$) mit einer Deckschicht aus Polyvinylalkohol überzogen.

Die Platten wurden unter einem Graustufenkeil mit einer 5-kW-Metallhalogenidlampe in einem Abstand von 110 cm so lange belichtet, daß das unter der Stufe 5 mit der optischen Dichte 0,80 liegende Feld gerade so durchpolymerisiert war, daß es bei der Entwicklung mit dem Entwickler aus Beispiel 1 nicht angegriffen wurde. Das Feld, das der Stufe 6 entsprach, wurde unter diesen Bedingungen durch die Entwicklung teilweise abgetragen.

Durch diese Verfahrensweise konnte für jedes Muster eine für eine optimale Auflösung und gute Druckauflage stehende Belichtungszeit ermittelt werden.

Die folgende Tabelle gibt die ermittelten Belichtungszeiten der verschiedenen Druckplatten wieder:

| Versuch | Belichtungszeit |
|---|---|
| A (V) | 20 Sekunden |
| B (V) | 20 " |
| C (V) | 25 " |
| D (V) | 40 " |
| E | 10 " |
| F | 8 " |
| G | 8 " |

| Versuch | Belichtungszeit |
|---|---|
| H | 8 " |
| I | 8 " |
| K | 8 " |
| L(V) | >100* " |
| M(V) | >100* " |
| N(V) | >100* " |

*Bei diesen Versuchen erfolgte keine Lichthärtung. Die Schicht löste sich bei der Entwicklung vollflächig ab.

Beispiel 3

Beschichtungslösungen aus

| | |
|---|---|
| 19 Gt | eines Copolymeren aus Methylmethacrylat und Methacrylsäure (98:2) mit einem Molekulargewicht von ca. 34.000, |
| 12 Gt | Trimethylolpropantriacrylat, |
| 0,2 Gt | Leukokristallviolett und |
| 0,1 Gt | Malachitgrün in |
| 69 Gt | Butanon |

wurden als Photoinitiatoren

| | | |
|---|---|---|
| A(V) | 0,2 Gt | 2-Methyl-4,6-bis(trichlormethyl)-s-triazin, |
| B(V) | 0,2 Gt | 2,2-Dibrommalonsäurebisamid, |
| C | 0,1 Gt | 9-Phenylacridin und |
| | 0,1 Gt | 2-Methyl-4,6-bis(trichlormethyl)-s-triazin, |
| D | 0,1 Gt | 9-Phenylacridin und |
| | 0,1 Gt | 2,2-Dibrommalonsäurebisamid oder |
| E(V) | 0,2 Gt | 9-Phenylacridin |

zugesetzt.

Die Lösungen wurden auf 25 µm dicke, biaxial verstreckte Polyethylenterephthalatfolie aufgebracht, so daß nach dem Trocknen bei 100 °C ein Schichtgewicht von 45 g/m$^2$ erhalten wurde.

Die so erhaltene Trockenresistfolie wurde mit einem handelsüblichen Laminator bei 120 °C auf eine mit 35 µm dicker Kupferfolie kaschierte Phenoplast-Schichtstoffplatte laminiert und 20 Sekunden unter einer Leiterplattenvorlage belichtet. Nach der Belichtung wurde auf den Platten C und D ein kontrastreiches Bild beobachtet, auf den Platten A, B und E entstand kein Bild.

Nach der anschließenden Sprühentwicklung mit Trichlorethan waren auf den Platten C und D die transparenten Teile der Vorlage abstandsgetreu als Resistflächen wiedergegeben. Auf den Platten A und B

blieben überhaupt keine lichtgehärteten Resistteile zurück, auf der Platte E nur ein unbrauchbares, sehr stark angegriffenes Bild der Vorlage.

Beispiel 4

Beschichtungslösungen aus

| | |
|---|---|
| 20 Gt | eines Terpolymerisats aus Styrol, n-Hexylmethacrylat und Methacrylsäure (10:60:30) mit der Säurezahl 190, |
| 20 Gt | des Umsetzungsproduktes aus 1 mol 2,2,4-Trimethyl-hexamethylendiisocyanat und 2 mol 2-Hydroxyethyl-methacrylat, |
| 0,02 Gt | 1,4-Bis-(4-tert-butoxy-phenylamino)-5,8-dihydroxyanthrachinon (Polysynthrengrün), |
| 0,35 Gt | Leukokristallviolett in |
| 46 Gt | Butanon und |
| 23 Gt | Ethanol |

wurden als Photoinitiatoren

| | | |
|---|---|---|
| A(V)<br>B(V) | 0,3 Gt<br>0,3 Gt | 9-Phenylacridin,<br>α,α-Dibrom-α-cyanomethyl-phenylsulfon, |
| C | 0,2 Gt<br>0,1 Gt | 9-Phenylacridin und<br>α,α-Dibrom-α-cyanomethyl-phenylsulfon, |
| D(V) | 0,3 Gt | 2,2-Dibrommalonsäure-bis-N-methylamid oder |
| E | 0,2 Gt<br>0,1 Gt | 9-Phenylacridin und<br>2,2-Dibrommalonsäure-bis-N-methylamid |

zugesetzt und diese Lösungen jeweils auf eine 25 µm starke Polyethylenterephthalatfolie aufgebracht. Anschließend wurde 2 Minuten bei 100 °C im Trockenschrank getrocknet. Man erhielt Trockenresistschichten mit einem Schichtgewicht von 50 g/m$^2$.

Um die Trockenresistschichten vor Verschmutzung durch Staub und Beschädigungen zu schützen, wurden sie mit einer 20 µm starken Deckfolie aus Polyethylen abgedeckt Dadurch können sie über einen längeren Zeitraum unter Lichtausschluß gelagert werden.

Nach Abziehen der Deckfolie wurde die Trockenresistschicht mit Hilfe eines handelsüblichen Laminators bei 120 °C und mit einer Geschwindigkeit von 1,5 m/min auf eine vorgereinigte Kupferfolie, die auf ein EpoxidGlasfaser-Hartgewebe kaschiert war, auflaminiert.

Die Proben A bis E des auf die Kupferoberfläche laminierten Resists wurden anschließend durch die Trägerfolie unter einer Vorlage belichtet, die ein Linienmuster mit je 140 µm breiten hellen und dunklen Balken sowie einen 13-stufigen Belichtungskeil mit Dichteinkrementen von 0,15 enthielt. Belichtet wurde mit einer eisendotierten 5-kW-Metallhalogenidlampe in einem Abstand von 80 cm 4 Sekunden lang.

Nach Abziehen der Trägerfolie wurden die belichteten Platten mit 0,8%iger Sodalösung bei 25 °C sprühentwickelt. Die Entwicklungszeit betrug jeweils ca. 60 Sekunden.

Die Muster B und D zeigten keine Lichtempfindlichkeit; sie waren durch den Entwicklungsprozeß voll abgelöst.

Die erfindungsgemäßen Muster C und E wiesen bis zur Stufe 6 vollständige Härtung auf, das Vergleichsmuster A dagegen nur bis zur 5. Stufe. Während beim Vergleichsmuster A die Balken des Linienmusters maßstabsgetreu wiedergegeben wurden, waren sie infolge einer Überbelichtung bei den Mustern C und E um 8 bis 10 % verbreitert. Um auch bei den Mustern C und E eine maßstabsgerechte 1:1-Wiedergabe zu erzielen, mußte bei diesen Schichten die Belichtungszeit von 4 auf 3 Sekunden reduziert werden. Das bedeutet, daß die Lichtempfindlichkeit der Muster C und E um ca. 35 % höher lag als die des Vergleichsmusters A.

Ähnlich gute Ergebnisse wurden erzielt, wenn das α,α-Dibrom-α-cyanomethyl-phenylsulfon in C z. B. durch α,α-Dibrom-α-cyanoessigsäuremorpholid oder 2-Methyl-4,6-bis(trichlormethyl)-s-triazin ersetzt wurde.

Beispiel 5

In Beschichtungslösungen aus

| | |
|---|---|
| 40 Gt | eines Terpolymerisats aus n-Hexylmethacrylat, Methacrylsäure und Styrol (60:30:10) mit einem mittleren Molekulargewicht von ca. 35.000 und der Säurezahl 195, |
| 40 Gt | des Umsetzungsproduktes aus 1 mol 2,2,4-Trimethyl-hexamethylendiisocyanat und 2 mol 2-Hydroxyethyl-methacrylat und |
| 0,4 Gt | eines Azofarbstoffs aus 2,4-Dinitro-6-chlorbenzoldiazoniumsalz und 2-Methoxy-5-acetylamino-N-cyanoethyl-N-hydroxyethylanilin in |
| 550 Gt | 1-Methoxy-propan-2-ol und |
| 120 Gt | Butanon |

wurden als Photoinitiatoren

| | | |
|---|---|---|
| A(V) | 0,5 Gt | 9-Phenylacridin, |
| B(V) | 0,5 Gt | Benz[a]phenazin, |
| C | 0,5 Gt<br>0,5 Gt | 9-Phenylacridin und<br>2-Methyl-4,6-bis(trichlormethyl)-s-triazin, |
| D | 0,5 Gt<br>0,5 Gt | Benz[a]phenazin und<br>2-Methyl-4,6-bis(trichlormethyl)-s-triazin, |
| E | 0,5 Gt<br>0,5 Gt | 9-Methyl-benz[a]phenazin und<br>2-Methyl-4,6-bis(trichlormethyl)-s-triazin, |
| F(V) | 0,5 Gt | 2-Methyl-4,6-bis(trichlormethyl)-s-triazin, |

gelöst. Die Lösungen wurden wie im Beispiel 1 auf vorbehandeltes Aluminium aufgebracht und nach dem Trocknen (Schichtgewicht 2,8 g/$m^2$) mit einer Deckschicht aus Polyvinylalkohol überzogen.

Die Platten wurden wie im Beispiel 2 so belichtet, daß durch eine einminütige Entwicklung mit dem Entwickler aus Beispiel 1 die Stufe 5 noch nicht angegriffen, die Stufe 6 aber bereits teilweise abgetragen wurde.

Folgende Belichtungszeiten wurden für die verschiedenen Versuche ermittelt:

| Versuch | Belichtungszeit |
|---|---|
| A (V) | 10,0 Sekunden |
| B (V) | 12,0 " |
| C | 7,0 " |
| D | 5,0 " |
| E | 5,0 " |
| F (V) | >100* " |

* Bei diesem Versuch erfolgte keine Lichthärtung.

Beispiel 6

In Beschichtungslösungen aus

| | |
|---|---|
| 14 Gt | eines Styrol-MaleinsäureanhydridMischpolymerisats mit einer Säurezahl von 190 und einem mittleren Molekulargewichtgewicht von 10.000, |
| 13 Gt | Trimethylolpropantriacrylat, |
| 2 Gt | beidseitig mit Methacrylsäure verestertem Polyethylenglykol (MG = 400) und |
| 0,25 Gt | Disperse Blue 134 (CI 61551) in |
| 170 Gt | 2-Methoxyethanol |

wurden als Photoinitiatoren

| | | |
|---|---|---|
| A(V) | 1,0 Gt | 9-(4'-Methoxyphenyl)-acridin, |
| B | 0,5 Gt<br>0,5 Gt | 9-(4'-Methoxyphenyl)-acridin und<br>2-Methyl-4,6-bis(trichlormethyl)-s-triazin, |
| C(V) | 0,5 Gt<br>0,5 Gt | 2-Benzoylmethylen-3-methyl-naphtho-[1,2-d]thiazolin und<br>2-Methyl-4,6-bis(trichlormethyl)-s-triazin, |
| D(V) | 1,0 Gt | 2-Methyl-4,6-bis(trichlormethyl)-s-triazin |

gelöst. Die Lösungen wurden wie in Beispiel 1 auf vorbenandeltes Aluminium aufgebracht und mit einer Deckschicht aus Polyvinylalkohol versehen. Anschließend wurde 15 Sekunden lang in einem Abstand von 110 cm unter einem Stufenkeil belichtet. Die Druckplatten wurden durch Überwischen mit einer Lösung aus

| | |
|---|---|
| 1,5 Gt | Natriummetasilikat-Nonahydrat, |
| 0,3 Gt | Polyglykol (MG = 6000), |
| 0,05 Gt | Lävulinsäure, |
| 0,03 Gt | Strontiumhydroxid-octahydrat in |
| 100 Gt | Wasser |

entwickelt.

| Versuch | Zahl der Stufen |
|---|---|
| A (V) | 2 |
| B | 7 |
| C (V) | 4 |
| D (V) | 0 |

Daneben wurden die Belichtungszeiten bestimmt, mit denen gerade die Fläche unter der Stufe 5 zu härten war, während die Fläche bei Stufe 6 bereits stark angegriffen wurde. Folgende Werte wurden erhalten:

| Versuch | Belichtungszeit |
|---|---|
| A (V) | 40 Sekunden |
| B | 7 " |
| C (V) | 21 " |
| D (V) | > 100* " |

* Bei diesem Versuch erfolgte keine Lichthärtung.

Beispiel 7

In Beschichtungslösungen aus

| | |
|---|---|
| 39 Gt | eines Copolymerisats aus Methylmethacrylat und Methacrylsäure (Säurezahl 115), |
| 39 Gt | Trimethylolethantriacrylat, |
| 0,1 Gt | Kristallviolett und |
| 1,5 Gt | Leukokristallviolett in |
| 450 Gt | 1-Methoxypropan-2-ol und |
| 75 Gt | Butanon |

wurden als Photoinitiatoren

| | | |
|---|---|---|
| A | 0,5 Gt<br>0,04 Gt | 9-Phenylacridin und<br>Tribrommethyl-phenylsulfon, |
| B | 0,5 Gt<br>0,4 Gt | 9-Phenylacridin und<br>Tribrommethyl-phenylsulfon |
| C | 0,5 Gt<br>2,0 Gt | 9-Phenylacridin und<br>Tribrommethyl-phenylsulfon, |
| D | 0,5 Gt<br>0,04 Gt | 9-Phenylacridin und<br>2-Methyl-4,6-bis(trichlormethyl)-s-triazin, |
| E | 0,5 Gt<br>0,4 Gt | 9-Phenylacridin und<br>2-Methyl-4,6-bis(trichlormethyl)-s-triazin, |
| F | 0,5 Gt<br>2,0 Gt | 9-Phenylacridin und<br>2-Methyl-4,6-bis(trichlormethyl)-s-triazin, |

zugesetzt. Es wurde wie in Beispiel 2 vorgegangen: Die Lösungen wurden auf vorbehandeltes Aluminium aufgebracht und nach dem Trocknen mit einer Deckschicht aus Polyvinylalkohol überzogen. Durch Belichtung unter einem Graustufenkeil wurden die Belichtungszeiten für eine optimale Auflösung ermittelt. Es ergaben sich folgende Werte:

| Versuch | Belichtungszeit |
|---|---|
| A | 10 Sekunden |
| B | 8 " |
| C | 8 " |
| D | 10 " |
| E | 8 " |
| F | 8 " |

Beispiel 8

Beschichtungslösungen aus

| | |
|---|---|
| 60 Gt | eines Terpolymerisats aus Methylmethacrylat, n-Hexylmethacrylat und Methacrylsäure (10:55:35) mit der Säurezahl 220, |
| 60 Gt | des Umsetzungsproduktes aus 1 mol 2,2,4-Trimethyl-hexamethylendiisocyanat und 2 mol 2-Hydroxyethyl-methacrylat, |
| 0,06 Gt | 1,4-Bis-(4-tert-butoxy-phenylamino)- 5,8-dihydroxyanthrachinon (Polysynthrengrün), |
| 1,05 Gt | Leukomalachitgrün in |
| 0,3 Gt | Mercaptobenzimidazol, |
| 0,3 Gt | Ascorbinsäure, |
| 138 Gt | Butanon und |
| 69 Gt | Ethanol |

wurden als Photoinitiatoren

| | | |
|---|---|---|
| A(V) | 0,35 Gt | 9-(p-Acetoxyphenyl)acridin, |
| B | 0,25 Gt<br>0,1 Gt | 9-(p-Acetoxyphenyl)acridin und<br>Tribrommethyl-phenylsulfon, |
| C | 0,25 Gt<br>0,1 Gt | 3-(p-Acetoxybenzyliden)-9-phenyl-2,3-dihydro-1H-cyclopenta[b]chinolin<br>Tribrommethyl-phenylsulfon |

zugesetzt und jeweils auf eine 25 µm starke Polyethylenterephthalatfolie aufgebracht. Anschließend wurde 2 Minuten bei 100 °C im Trockenschrank getrocknet. Man erhielt Trockenresistschichten mit einem Schichtgewicht von 45 g/m$^2$.

Um die Trockenresistschichten vor Verschmutzung durch Staub und Beschädigungen zu schützen, wurden sie wie im Beispiel 4 mit einer 20 µm starken Deckfolie aus Polyethylen abgedeckt.

Nach Abziehen der Deckfolie wurde die Trockenresistschicht mit Hilfe eines handelsüblichen Laminators bei 120 °C und mit einer Geschwindigkeit von 1,5 m/min auf eine vorgereinigte Kupferfolie, die auf ein EpoxidGlasfaser-Hartgewebe kaschiert war, auflaminiert.

Die Proben A bis C des auf die Kupferoberfläche laminierten Resists wurden anschließend durch die Trägerfolie unter einer Vorlage belichtet, die ein Linienmuster mit je 100 µm breiten hellen und dunklen Balken enthielt. Belichtet wurde mit einer eisendotierten 5-kW-Metallhalogenidlampe in einem Abstand von 95 cm 3, 4, 5 und 6 Sekunden lang.

Nach Abziehen der Trägerfolie wurden die belichteten Platten mit 1 %iger Sodalösung bei 25 °C sprühentwickelt. Die Entwicklungszeit betrug jeweils ca. 60 Sekunden.

Anschließend wurde ermittelt, bei welcher Belichtung die Linien optimal wiedergegeben wurden. Beim Muster A waren dies 6 Sekunden; eine kürzere Belichtung bewirkte ungenügende Lichthärtung und dadurch bedingt schmalere, ausgewaschene Linien. Die optimale Belichtung des Musters B waren 3 Sekunden, die von C 4 Sekunden; längere Belichtung bewirkte eine Linienverbreiterung, d.h. mit 6 Sekunden waren die Proben B und C überbelichtet.

**Patentansprüche**

**1.** Photopolymerisierbares Gemisch, das als wesentliche Bestandteile

a) ein polymeres Bindemittel,

b) eine Verbindung mit mindestens einer endständigen ethylenischen Doppelbindung und

c) eine Acridin-, Phenazin- oder 2,3-Dihydro-1H-cyclopenta[b]chinolinverbindung als Photoinitiator

enthält, dadurch gekennzeichnet, daß das Gemisch zusätzlich eine Halogenverbindung einer der allgemeinen Formeln I und II

$$X^1 - \underset{\displaystyle Z}{\overset{\displaystyle Y}{\underset{|}{\overset{|}{C}}}} - (A)_n - B - D \qquad (I)$$

$$(X^1 - \underset{\displaystyle X^3}{\overset{\displaystyle X^2}{\underset{|}{\overset{|}{C}}}} -)_m W \qquad (II)$$

enthält, worin

| | |
|---|---|
| $X^1$ | Chlor oder Brom bedeutet, |
| $X^2$ und $X^3$ | gleich oder verschieden sind und $X^1$, Wasserstoff oder Alkylgruppen bedeuten, |
| Y und Z | gleich oder verschieden sind und $X^1$, Wasserstoff, CM oder $(A)_n$-$(B)_n$-D bedeuten, |
| A | eine Phenylengruppe, |
| n | 0 oder 1, |
| B | CO oder $SO_2$, |
| D | R, OR, NHR, $NH_2$, $NR_2$ oder $CX^1X^2X^3$, |
| R | ein Alkyl-, Cycloalkyl-, Aryl- oder Heteroylrest, |
| W | ein 5- oder 6-gliedriger heterocyclischer Ring mit 1 bis 3 Heteroatomen, der ggf. Substituenten und ggf. einen anellierten aromatischen Ring trägt, und |
| m | 1 oder 2 ist. |

**2.** Photopolymerisierbares Gemisch nach Anspruch 1, dadurch gekennzeichnet, daß die N-heterocyclische Verbindung ein in 9-Stellung arylsubstituiertes Acridin ist.

**3.** Photopolymerisierbares Gemisch nach Anspruch 1, dadurch gekennzeichnet, daß die Halogenverbindung der Formel I Tribrommethylphenylsulfon, 2,2-Dibrommalonsäurebisamid, $\alpha,\alpha$-Dibrom-$\alpha$-cyanomethylphenylsulfon, $\alpha,\alpha$-Dibrom-$\alpha$-benzoylmethyl-phenylsulfon oder $\alpha,\alpha$-Dibrommalonsäure-bis-N-methylamid ist.

**4.** Photopolymerisierbares Gemisch nach Anspruch 1, dadurch gekenzeichnet, daß die Halogenverbindung der Formel II ein in 2-Stellung substituiertes 4,6-Bis(trichlormethyl)-s-triazin oder ein 2-Tribrommethylchinolin ist.

**5.** Photopolymerisierbares Gemisch nach Anspruch 4, dadurch gekenzeichnet, daß der Substituent in 2-Stellung ein Alkyl- oder Arylrest ist.

**6.** Photopolymerisierbares Gemisch nach Anspruch 1, dadurch gekenzeichnet, daß die Verbindungen der Formeln I und II jeweils zu 0,01 bis 3,0 Gew.-% enthalten sind.

**7.** Photopolymerisierbares Gemisch nach Anspruch 1, dadurch gekennzeichnet, daß es ferner einen Farbstoff oder eine Kombination eines Farbstoffs mit einem Leukofarbstoff enthält.

**8.** Photopolymerisierbares Gemisch nach Anspruch 1, dadurch gekennzeichnet, daß das polymere Bindemittel wasserunlöslich und in wäßrig-alkalischer Lösung löslich ist.

**9.** Photopolymerisierbares Gemisch nach Anspruch 8, dadurch gekennzeichnet, daß das polymere Bindemittel eine Säurezahl von 50 bis 350 aufweist.

**10.** Photopolymerisierbares Aufzeichnungsmaterial mit einem Schichtträger und einer photopolymerisierbaren Schicht, dadurch gekennzeichnet, daß die Schicht aus einem Gemisch gemäß Anspruch 1 besteht.

**11.** Photopolymerisierbares Aufzeichnungsmaterial nach Anspruch 10, dadurch gekennzeichnet, daß der Schichtträger eine Oberfläche aus Aluminium, Kupfer, Aluminium- oder Kupferlegierung trägt.

**12.** Photopolymerisierbares Aufzeichnungsmaterial nach Anspruch 12, dadurch gekennzeichnet, daß der Schichtträger eine transparente Kunststoffolie ist.

## Claims

**1.** A photopolymerizable composition which contains,as the essential constituents,

a) a polymeric binder,

b) a compound having at least one terminal ethylenic double bond, and

c) an acridine, phenazine or 2,3-dihydro-1H-cyclopenta[b]quinoline compound, as the photoinitiator,

wherein the composition additionally contains a halogen compound corresponding to one of the general formuale I and II

$$X^1 - \underset{Z}{\overset{Y}{C}} - (A)_n - B - D \qquad (I)$$

$$(X^1 - \underset{X^3}{\overset{X^2}{C}} -)_m W \qquad (II)$$

in which

| | |
|---|---|
| $X^1$ | stands for chlorine or bromine, |
| $X^2$ and $X^3$ | are identical or different and denote $X^1$, hydrogen or alkyl groups, |
| Y and Z | are identical or different and denote $X^1$, hydrogen, CN or $(A)_n$-$(B)_n$-D, |
| A | is a phenylene group, |
| n | is 0 or 1, |
| B | is CO or $SO_2$, |
| D | is R, OR, NHR, $NH_2$, $NR_2$ or $CX^1X^2X^3$, |
| R | is an alkyl, cycloalkyl, aryl or heteroyl radical, |
| W | is a five or six-membered heterocyclic ring having from 1 to 3 heteroatoms, which optionally carries substituents and optionally a fused aromatic ring, and |
| m | is 1 or 2. |

**2.** A photopolymerizable composition as claimed in claim 1, wherein the N-heterocyclic compound is an acridine which is aryl-substituted in the 9-position.

**3.** A photopolymerizable composition as claimed in claim 1, wherein the halogen compound of formula I comprises tribromomethyl-phenylsulfone, 2,2-dibromomalonic diamide, $\alpha,\alpha$-dibromo-$\alpha$-cyanomethyl-phenylsulfone, $\alpha,\alpha$-dibromo-$\alpha$-benzoylmethyl-phenylsulfone, or $\alpha,\alpha$-dibromomalonic-bis-N-methylamide.

**4.** A photopolymerizable composition as claimed in claim 1, wherein the halogen compound of formula II is a 4,6-bis(trichloromethyl)-s-triazine substituted in the 2-position or a 2-tribromomethylquinoline.

**5.** A photopolymerizable composition as claimed in claim 4, wherein the substituent in the 2-position is an alkyl or aryl radical.

**6.** A photopolymerizable composition as claimed in claim 1, which contains the compounds of formulae I and II in each case in an amount of from 0.01 to 3.0 percent by weight.

7. A photopolymerizable composition as claimed in claim 1, which additionally contains a dye or a combination of a dye with a leuco dye.

8. A photopolymerizable composition as claimed in claim 1, wherein the polymeric binder is insoluble in water and soluble in an aqueous-alkaline solution.

9. A photopolymerizable composition as claimed in claim 8, wherein the polymeric binder has an acid number of from 50 to 350.

10. A photopolymerizable recording material comprising a layer support and photopolymerizable layer, wherein the layer is formed of a composition as claimed in claim 1.

11. A photopolymerizable recording material as claimed in claim 10, wherein the layer support has a surface comprising aluminum, copper or an aluminum or copper alloy.

12. A photopolymerizable recording material as claimed in claim 11, wherein the layer support is a transparent plastic film.

**Revendications**

1. Composition photopolymérisable, contenant en tant que composants essentiels
   a) un liant polymère,
   b) un composé comportant au moins une double liaison éthylénique terminale et
   c) un composé acridine, phénazine ou 2,3-dihydro-1H-cyclopenta[b]quinoléine, en tant que photo-initiateur.

   caractérisée en ce que la composition contient en outre un composé halogéné correspondant à l'une des formules générales I et II

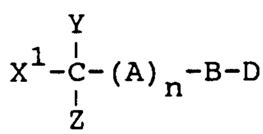

(I)

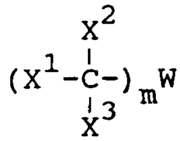

(II)

dans lesquelles

| | |
|---|---|
| $X^1$ | représente un atome de chlore ou de brome, |
| $X^2$ et $X^3$ | sont identiques ou différents et représentent $X^1$, un atome d'hydrogène ou un groupe alkyle, |
| Y et Z | sont identiques ou différents et représente $X^1$, un atome d'hydrogène, CN ou$(A)_n$-$(B)_n$-D, |
| A | représente le groupe phénylène, |
| n | est 0 ou 1, |
| B | est CO ou $SO_2$, |
| D | est R, OR, NHR, $NH_2$, $NR_2$ ou $CX^1X^2X^3$, |
| R | représente un radical alkyle, cycloalkyle, aryle ou hétéroyle, |
| W | représente un cycle hétérocyclique à 5 ou 6 chaînons, ayant de 1 à 3 hétéroatomes, qui porte éventuellement des substituants et éventuellement un cycle aromatique soudé, et |
| m | est 1 ou 2. |

2. Composition photopolymérisable selon la revendication 1, caractérisée en ce que le composé N-hétérocyclique est une acridine substituée par un groupe aryle en position 9.

3. Composition photopolymérisable selon la revendication 1, caractérisée en ce que le composé halogéné de formule I est la tribromométhylphénylsulfone, le 2,2-dibromomalonamide, l'α,α-dibromo-α-cyanométhylphénylsulfone, l'α,α-dibromo-α-benzoylméthylphénylsulfone ou l'α,α-dibromomalonyl-bis-N-méthylamide.

**4.** Composition photopolymérisable selon la revendication 1, caractérisée en ce que le composé halogéné de formule II est une 4,6-bis(trichlorométhyl)-s-triazine substituée en position 2 ou une 2-tribromométhylquinoléine.

**5.** Composition photopolymérisable selon la revendication 4, caractérisée en ce que le substituant en position 2 est un radical alkyle ou aryle.

**6.** Composition photopolymérisable selon la revendication 1, caractérisée en ce que les composés de formules I et II sont contenus chacun à raison de 0,01 à 3,0 % en poids.

**7.** Composition photopolymérisable selon la revendication 1, caractérisée en ce qu'elle contient en outre un colorant ou une association d'un colorant avec un leuco-dérivé de colorant.

**8.** Composition photopolymérisable selon la revendication 1, caractérisée en ce que le liant polymère est insoluble dans l'eau et soluble dans une solution aqueuse-alcaline.

**9.** Composition photopolymérisable selon la revendication 8, caractérisée en ce que le liant polymère a un indice d'acide allant de 50 à 350.

**10.** Matériau de reprographie photopolymérisable comportant un support de couche et une couche photopolymérisable, caractérisé en ce que la couche est constituée d'une composition selon la revendication 1.

**11.** Matériau de reprographie photopolymérisable selon la revendication 10, caractérisé en ce que le support de couche comporte une surface d'aluminium, de cuivre ou d'un alliage d'aluminium ou de cuivre.

**12.** Matériau de reprographie photopolymérisable selon la revendication 11, caractérisé en ce que le support de couche est une feuille de matière plastique transparente.